Europäisches Patentamt

European Patent Office

Office européen des brevets

(11) Publication number: **0 269 410 B1**

# EUROPEAN PATENT SPECIFICATION

(45) Date of publication of patent specification: **22.04.92**  (51) Int. Cl.⁵: **B65D 81/26**

(21) Application number: **87310344.4**

(22) Date of filing: **24.11.87**

Divisional application 91202052.6 filed on 24/11/87.

(54) **Packaging of semiconductor elements.**

(30) Priority: **25.11.86 JP 278610/86**
     **21.08.87 JP 206290/87**

(43) Date of publication of application:
    **01.06.88 Bulletin 88/22**

(45) Publication of the grant of the patent:
    **22.04.92 Bulletin 92/17**

(84) Designated Contracting States:
    **DE FR GB IT**

(56) References cited:
    **EP-A- 0 038 179**
    **DE-C- 922 516**
    **GB-A- 1 128 155**
    **US-A- 2 251 609**
    **US-A- 2 446 361**

(73) Proprietor: **HITACHI, LTD.**
    **6, Kanda Surugadai 4-chome**
    **Chiyoda-ku, Tokyo 101(JP)**

(72) Inventor: **Kitamura, Wahei**
    **No. 303, 17-1, Gakuennishi-machi 1-chome**
    **Kodaira-shi Tokyo(JP)**
    Inventor: **Murakami, Gen**
    **3048, Onoji-machi**
    **Machida-shi Tokyo(JP)**
    Inventor: **Nishi, Kunihiko**
    **13-20, Kita-machi 4-chome**
    **Kokubunji-shi Tokyo(JP)**

(74) Representative: **Calderbank, Thomas Roger et al**
    **MEWBURN ELLIS & CO. 2/3 Cursitor Street**
    **London EC4A 1BO(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to the packaging of semiconductor elements in suitable containers.

It is now common for semiconductor elements, such as IC chips enclosed in resin, to be packaged within a suitable container for transportation. Various types of packages are known, such as small outline packages (SOP), quad flat packages (QFP), plastic leaded chip carrier (PLCC), and similar known packages. By way of general background, packaging of semiconductor elements is discussed in "IC Packaging Technique", published by Kogyo Chosaki KK, 15th January, 1980, pp. 135-156.

As the size of semiconductor elements increases, the effective strength of the element tends to decrease. Furthermore, great problems can arise if moisture enters the element. When a semiconductor element is surface-mounted to a mounting substrate such as a printed circuit board, heat is applied to the element at various times, as at the time of solder reflow. Moisture which has come into contact with the semiconductor element within the package can cause damage to the element when the heat is applied, and therefore it is important that the element be as dry as possible before the mounting operation is carried out. This problem is particularly acute when the element comprises a resin-encapsulated semiconductor device.

EP-A-0038179 describes packaging of semiconductor elements for transportation. It discloses packaging corresponding to the pre-characterising part of claim 1. However, the document does not relate to a packaging which can be used to prevent moisture coming into contact with surface mounting types semiconductor elements.

To cope with this problem, it has been customary to bake the package at e.g. 125°C for a suitable period, which may be as long as 16 to 24 hours, before any heat is applied to the element to attach it to a mounting substrate. However, this method is inefficient because a suitable furnace must be provided to bake the package, and the time for which the package must be baked is long.

The inventors of the present application have found that the moisture which can cause damage to the semiconductor element comes primarily from moisture in the air which enters the package during the period from the completion of manufacture of the semiconductor element (normally at the time the device is enclosed in resin) to the time that the package is mounted on a suitable substrate. The cause of the moisture on the element is due largely to condensation within the package.

Japanese Patent Laid-Open No. 178877/1986 by Otsuka et al, discloses, as alternatives, the placing of a desiccant within a standard semiconductor element magazine, or the covering of a tray for supporting semiconductor elements within a container of vinyl sheet. The arrangements disclosed in this document go a long way to reducing moisture, but do not solve the problem completely, particularly where the size of the packages are reduced.

Therefore, the present invention seeks to provide a way of reducing, or eliminating, moisture within a package for one or more semiconductor elements, and hence prevent subsequent damage to the element due to that moisture. Firstly, according to the present invention, one or more semiconductor elements are sealed within a moisture-proof container. However, this in itself is not sufficient to overcome the problem of moisture, since the air within the container may itself contain moisture, and also there is the possibility that there may be some leakage of moisture through the container. Therefore, the present invention provides a number of features which, either individually, or in combination, can be used to overcome the moisture problem.

Firstly, the container may contain a drying agent, such as a desiccant. In this way, the drying agent removes the moisture from the air within the package, and so prevents that moisture condensing onto the semiconductor element. The desiccant may be attached to an inner surface of the container, and/or may be more proximate the semiconductor element(s).

Secondly, the material of the enclosing container may be of a multi-layered film containing at least one metal sheet. The metal sheet has a lower vapour permeability than organic films, such as plastic films, and may therefore prevent the passage of moisture through the material of the container. Furthermore, the metal layer may resist the formation of pin-holes within the container material. A conductive layer may also be provided in the multi-layered film of the container, and this will normally have to be protected by one or more additional plastics layers.

Thirdly, the present invention may provide a humidity indicator within the container to indicate whether or not an excessive amount of moisture has entered the package, and so come in contact with the semiconductor element. The humidity indicator is preferably mounted on an inner surface of the container itself, and is visible through the container material. This may be done by the use of a transparent container, or, for example where the container is made of a multi-layered film containing a metal sheet, as discussed above, then a transparent window may be provided in an otherwise opaque container.

Any one or more of the above solutions to the problem of moisture may be provided for a container for a single semiconductor element. However, it is more usual that the present invention will be applied to the packaging of a plurality of semiconductor elements, normally at least 10. Then, the semiconductor elements are stored in or in one or more suitable carrier members, which are then enclosed within the container.

Many different carrier members may be used with the present invention. For example, the carrier member may be a tube-like magazine for storing a number of semiconductor elements arranged in a line. Alternatively, the carrier member may be a tray for storing the semiconductor elements in the form of an array. It is also possible to use a tape-like support as the carrier member, in which case the tape-like member may be stored in the container when wound on a reel. The semiconductor elements are bonded onto the tape, at spaced-apart intervals.

It is possible, furthermore, to provide a plurality of such carrier members within an inner box of e.g. paper, which is then enclosed in the container. Indeed, this packaging may be taken further, to provide an assembly of such containers, which may then be contained in an outer box of e.g. cardboard for transportation.

To produce such a package, the semiconductor element(s) are suitably positioned, e.g. on or in the carrier member as appropriate, and then enclosed in a film forming the container. To seal the container, it may be press-sealed air-tight and an ultrasonic wave or heat applied to it to cause a bond to be formed. Of course, it is important that the container does not contain any hygroscopic material other than the semiconductor elements and, where it is used, the drying agent (desiccant).

The air in the package may be partially removed, to reduce the amount of moisture present within it. Furthermore, where the package contains an inner box containing several carrier members for semiconductor elements, the material of the container will then be brought into contact with the surface of the box. This is useful, for example, as the use of a transparent container then enables information on the surface of the box to be read easily. It also makes the subsequent storage of the package, e.g. in an outer box, easier.

Another possibility for reducing moisture is to substitute the air within the package by a suitable drying gas.

A further development arises when it is desired to check that there are no pin-holes or other flaws in the container which could permit the subsequent entry of moisture. For example, a gas may be pumped into the container, so that the existence of pin-holes may be determined by the amount of expansion of the bag, or by its subsequent deflation.

Thus the present invention provides a package comprising:

a semiconductor element (3,12) having at least one semiconductor chip on which at least one electronic device is formed which semiconductor element (3,12) has not been mounted on an element substrate, and has at least one resin moulded member (41) covering all the main plane of the at least one chip; and

a bag member (8,17) which surrounds the element (3,12) and seals the element in an air-tight manner;

characterised in that:

the element (3,12) is a surface mounting semiconductor element; and the bag member (8,17) comprises a multi-layered film containing at least one metal sheet (35) whereby moisture is prevented from reaching the element in the package so that cracking and interface peeling of the element can be avoided when mounting the element on an element substrate.

The present invention also provides an air-tight package made of a moisture-proof film which package comprises:

a plurality of semiconductor elements (3,12) which have not been mounted on an element substrate and each element includes a resin moulded semi conductor device;;

a plurality of storage magazines (2,13) arranged in lines and in close contact with one another for storage therein of said semiconductor elements (3,12);

a bag member (8,17) which surrounds the elements (3,12) and seals the elements (3,12) and magazines (2,13) in an air-tight manner;

characterised in that:

the elements (3,12) are surface mounting semiconductor elements;

the bag member (8,17) comprises a moisture-proofing sheet member, which is a multi-layered film, whereby moisture is prevented from reaching the elements in the package so that cracking and intersurface peeling of the element can be avoided when mounting the element on an element substrate;

an interior box (1) which contains said semiconductor element storage magazines (2,13) is provided within the bag member (8,17); and

a dessicant (5) is provided within the bag member (8,17).

Thus, the present invention may provide an efficient method of making semiconductor elements. It is reliable, permits a high packaging density, and makes transportation of the semiconductor elements both simple and safe. It is particularly, but not exclusively, appropriate for resin-moulded electronic components, particularly those in which the electronic devices are sealed by a thin resin encapsulant, which is easily damaged by moisture.

For example, it may be applied to surface mount semiconductor elements. It reduces, or eliminates, the need for baking of the semiconductor elements, even when they have been stored for a long period. Furthermore, by use of the humidity indicator, the amount of moisture absorbed by the semiconductor elements may be detected easily, so enabling selection of those elements which need suitable treatment e.g. drying, before they can be used. In general, with the present invention, the use of a drying agent, such as a desiccant, effectively eliminates the moisture inside the container and so prevents condensation, even at low temperatures .

The present invention is suitable for automatic packaging techniques.

Before describing embodiments of the invention in detail, we will describe particular arrangements utilizing the present invention.

In a first arrangement, surface mount package type semiconductor elements, stored in a magazine are put into an inner box, a desiccant such as silica gel is put into the inner box, and the inner box is then placed into a transparent resin bag. The bag has, as the base, a polyester having moisture permeability of up to $2.0/m^2$.24 hours, for example, and having a surface intrinsic resistance of $10^6$ ohms on the outside and up to $10^{11}$ ohms on the inner side, and the open portion of the bag is heat-sealed after removing the air.

According to this arrangement, the surface mount package type package is stored in the inner box and the moisture-proofing bag outside the box is sealed completely by deaeration and by a heat seal. Hence the elements are free from the influences of external moisture. Therefore, the interface peel and cracking of the elements does not occur even after solder reflow. The need for a troublesome baking operation is eliminated. Because a polyester having moisture permeability of up to 2.0 $g/m^2$.24 hours is used as the base of the resin bag in this arrangement, moisture-proofing is high and a heat seal is possible so that the effect of checking intrusion of the external air is high. The surface intrinsic resistance of the bag is up to $10^{11}$ ohms on its inner surface and up to $10^6$ ohms on its outer surface in order to prevent any charge. Furthermore, silica gel may be placed between the magazine and a wall of the inner box in order to absorb moisture so that the surface package type package is not much affected by the external moisture.

Of course it is also possible to provide a plurality of such magazines in the inner box, before enclosing the box in the bag.

In another arrangement, a package of a number of (e.g. about 10) resin-molded semiconductor devices which are stored in a plastic magazine, whose outside portion is sealed airtight by a moisture-proofing film may be provided.

Another arrangement comprises an outer box made of a cardboard, a plurality (at least five to six) packaging bags made of a moisture-proofing film and sealed airtight, and a plurality of inner boxes made of paper stored in each packaging bag. A plurality of support members such as tube-like magazines for containing the semiconductor elements are stored in the inner boxes, respectively, and a number of surface package type resin-molded semiconductor integrated circuit devices stored in the magazines, respectively. A desiccant may be stored in each of the inner boxes, or in the packaging bag.

Alternatively, or in addition, a humidity indicator may be provided in the bag. Normally, the humidity indicator will be attached to an inner surface of the bag, so that it is visible therethrough, and the desiccant may also be fixed on an inner surface of the bag, or in the inner boxes.

The magazines may be closely aligned, with their ends adjacent, as this permits the size of the package to be minimised.

In another arrangement, the package may comprise a tube-like magazine containing a line of a plurality (at least five to six) of e.g. resin-molded semiconductor elements. Then a humidity indicator is provided in the magazine so that it is visible from outside the package.

In another arrangement at least one resin-molded semiconductor element is packaged in a packaging bag made of a moisture-proofing film which is sealed airtight. A drying member is stored or formed inside the packaging bag so as to be visible from outside.

As was mentioned above, the present invention is applicable not only to the packaging of large numbers of semiconductor elements, but also to the packaging of individual elements. One arrangement which utilizes this provides an airtight package for resin-molded semiconductor elements, which comprises a carrier tape made of a first moisture-proofing resin sheet and having recesses, for storing semiconductor elements. A plurality of resin-molded semiconductor elements may then be stored in the recesses, and a second moisture-proofing resin sheet covering the upper surface of the recesses and sealed in such a manner as to keep the inside of each recess airtight. A drying agent (desiccant) may be provided in each recess.

After the semiconductor elements have been stored, with the resin-molded semiconductor devices enclosed in a moisture-proofing bag lest they should absorb moisture, the devices may be taken out of the bag, and placed on a wiring substrate. The leads of the resin-molded devices may then be soldered to the wirings on the wiring substrate with the resin-molded part of the devices receiving thermal impact.

Prior to enclosure in the container (bag) the resin-molded semiconductor devices may be fabricated by sealing a semiconductor chip and inner leads by a resin. An ink mark may then be applied to the resulting resin-molded member, and the resin-molded member as a whole after marking exposed to a high temperature for baking the ink. The elements (devices) are then sealed airtight after completion before they absorb moisture.

Thus, in the fabrication of a semiconductor memory device, leads are fixed to semiconductor chip holding portions made of the same metal sheet as that of the leads through one of the main planes of the chip. Then pads are bonded on the other main plane of the chip to inner leads by a bonding wire, and the chip is coated with an organic resin causing a reduction in $\alpha$-particle defects in at least a region of the other main plane of the chip, where memory cells are formed. A resin-molded element is thus formed from which a plurality of leads projects, by molding the chip, the wires, the chip holding members and the inner leads in a resin. The resin-molded element is the packaged in a moisture-proofing bag lest the resin-molded element absorbs moisture.

Embodiments of the invention will now be described in detail, by way of example, with reference to the accompanying drawings, in which:

Fig. 1 is a perspective view of a package in accordance with a first embodiment of the present invention;

Fig. 2 is a perspective view of an inner box in the first embodiment described above;

Fig. 3 is a perspective view showing an example of a magazine;

Fig. 4 is a sectional view of an end part of the magazine;

Fig. 5 shows an example of a bag which may be used as the container of the present invention;

Fig. 6 is a perspective view showing the appearance and construction of a transparent moisture-proof package in accordance with a second embodiment of the present invention;

Fig. 7 is an enlarged sectional view taken along line II-II of Fig. 6 and shows the fitting of a humidity indicator fitted to the inner surface of a transparent bag-like moisture-proofing container;

Fig. 8 is a partially cut-away perspective view showing the structure of the transparent bag-like container shown in Fig. 6;

Fig. 9 is a perspective view showing the appearance and construction of a transparent moisture-proof package in accordance with a third embodiment of the present invention;

Fig. 10 is an enlarged sectional view taken along line II-II in Fig. 9 showing a humidity indicator fitted to the inner side surface of the container of the package;

Fig. 11 is a partially cut-away perspective view showing the structure of a film forming the moisture-proof package container shown in Fig. 9;

Figs. 12 to 17 are sectional views showing the appearance of resin-molded semiconductor devices to which the first to third embodiments of the present invention may be applied;

Figs. 18 to 21 show examples of support members which may be used in the first to third embodiments of the present invention, respectively;

Fig. 22 is an explanatory view showing in detail a packaging method useful for the first to third embodiments of the present invention;

Fig. 23 is a sectional view of a memory IC device which may be packaged in the way discussed with reference to the first to third embodiments of the present invention;

Fig. 24 is a schematic view showing the mounting of such devices on a substrate; and

Fig. 25 is a schematic view of a solder dipping method for such a device.

## Embodiment 1

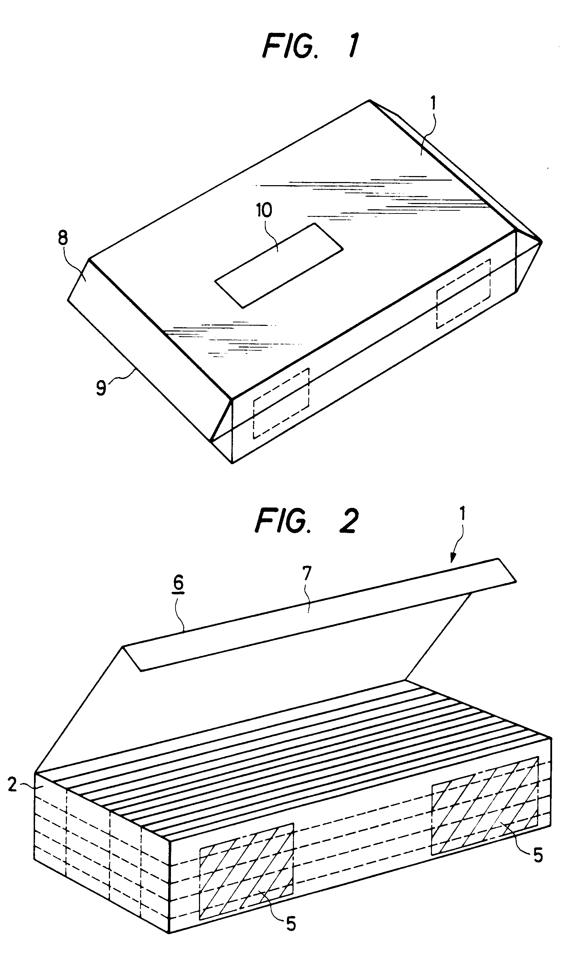

The first embodiment of the present invention is concerned with the packaging of large numbers of semiconductor elements, and will be described with reference to Figs. 1 to 5.

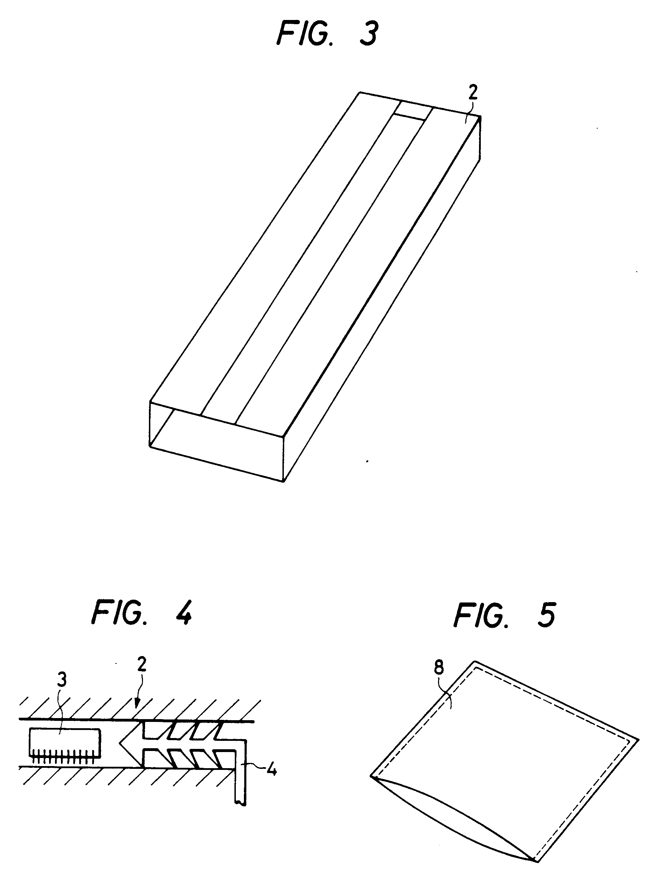

A plurality of magazines 2 are stored in an inner box 1 made of paper, as shown in Fig. 2. An example of one such magazine is shown in Fig. 3. Each magazine 2 contains several (e.g. five) surface mount package type semiconductor elements 3 and a stopper 4 is fitted to the end of the magazine 2 in order to prevent projection to the end element 3 from the magazine 2.

A desiccant such as silica gel 5 is put between the wall of the inner box 1 and the side surfaces of the magazine 2 as shown in Fig. 2. Preferably, the silica gel 5 is also put into the ends of the magazine, in each case for absorbing moisture. The flange 7 of a lid 6 is folded inward and the lid 6 is closed. When a package 3 is taken out by lifting the lid 6, the inner surface of the lid 6 may be affected by external moisture. For this reason, it is advisable to place silica gel on the inner side of the lid.

The box 1 is put into a bag 8 such as shown in Fig. 5 and after deaeration, the open portion 9 of the bag 8 is heat-sealed.

The bag 8 is made of a transparent, electrically conductive film using a polyester having moisture permeability of up to 2.0 g/m2.24 hours as the base.

It is convenient for the bag 8 to be transparent, because information describing the products, such as quantity, production lot number, and so forth, may then be put on the surface of the box 1.

An example of a film suitable to form the conductive bag 8 is a laminate film prepared by laminating a polyethylene containing an antistatic agent kneaded therein, a polyester film, a carbon conductive layer and an acrylic resin protective film in order named from the inside. The laminate may further be coated with a vinylidene chloride film. To prevent charge of IC(s) inside the package 8, the surface intrinsic resistance of the conductive bag is up to $10^6$ ohms on the outer surface and up to $10^{11}$ ohms on the inner surface.

Warnings to notifying the user that the devices should be used rapidly after opening the bag and the bag should be kept in the environment of low humidity may be printed on the surface of the bag 8 or a label 10 bearing such warnings may be bonded to the bag 8.

Thus, the surface mount package type elements 3 are kept in the moisture-proofing bag 8 and are sealed completely by deaeration and the heat seal 9. Since the silica gel 5 absorbs the moisture on the outside of the magazines 2 and the elements 3 are not affected by external moisture, baking of the package or the elements before use becomes unnecessary and even after solder reflow, peel of interface and crack of the elements can be prevented.

Other desiccants can be used in the embodiment described above in place of silica gel.

Embodiment 2

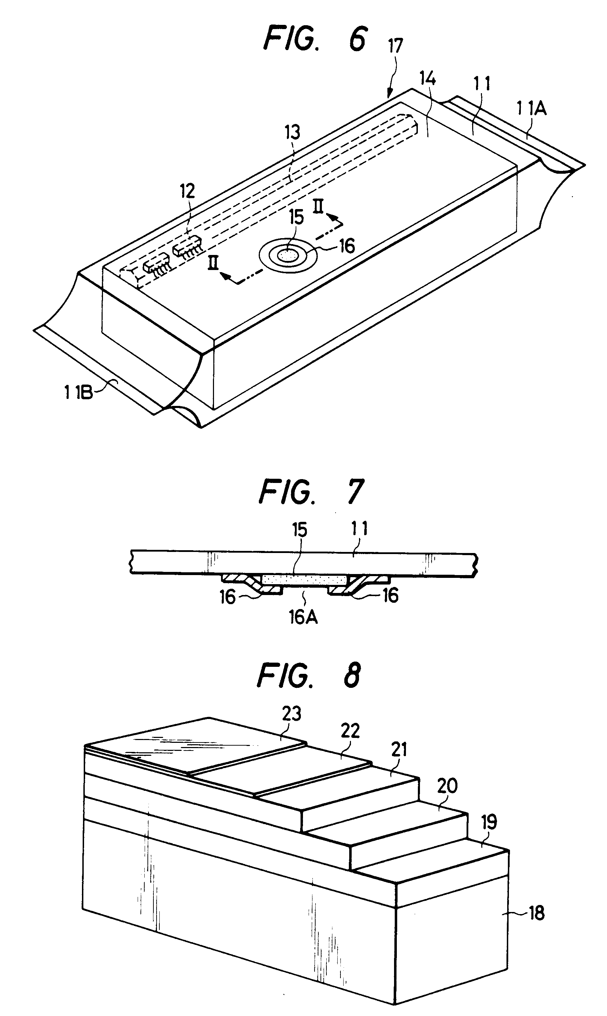

A second embodiment of the present invention will now be described with reference to Figs. 6 to 8.

Fig. 6 is a perspective view showing the appearance and structure of a transparent package of this embodiment.

As shown in Fig. 6, the package of this embodiment is made of a transparent moisture-proof film 11. A plurality of electronic components 12 such as surface mount package type semiconductor devices are stored inone or more carrier members e.g. containers 13 in the form of tube-like magazines and the containers 13 are stored in an inner box 14. Furthermore, the inner box 14 is enclosed in the film 11, the ends 11A,11B of which are sealed, to form a bag 17. When the moisture-proof package is made, a humidity indicator 15 for detecting the humidity inside the bag 17 is provided on the inner surface of the film 11 at a position where the indicator 15 can be seen from outside.

Examples of this humidity indicator 15 are as follows:

(i) A warning may be printed on the inner surface of the film 11 using an ink containing a material which changes colour when exposed to moisture, such as cobalt chloride. This printed warning then serves as the humidity indicator 15. For example, the warning may read "When the colour of this warning changes from blue to thin violet, take out the semiconductor devices from the bag and bake them at 125°C for 24 hours".

(ii) As shown in Figs. 6 and 7, a humidity indicator (humidity detection label) 15 may be bonded to the inner surface of the film 11 by an adhesive 16 having vent holes 16A so that it can be seen from outside the bag 17. This humidity detection label is prepared, for example, by letting paper made of a pulp absorb a material which changes colour in the presence of humidity, such as cobalt chloride.

(iii) The humidity indicator (humidity detection label) 16 may be bonded to the inner box 14 inside the bag 17 or a warning may be printed thereon, using a material which changes colour when exposed to moisture, such as cobalt chloride.

Incidentally, when the humidity indicator (humidity detection label) 15 is bonded to the film 11 or the inner box 14, there is no need to print a separate warning.

Next, the structure of the film 11 will be discussed with reference to Fig. 8. In Fig. 8, there is shown a polyethylene layer 18 into which an antistatic agent is kneaded. This is the innermost layer of the film 11. The polyethylene layer 18 may be 63 $\mu$m thick, for example, and prevents frictional charge, permits heat sealing of the bag 17, determines the ease of opening the bag 17, and so forth. There is polyester film layer 19 for pin-hole proofing on the polyethylene layer 18, and there is a polyester film layer 20 having a barrier layer for preventing intrusion of moisture on the polyester film layer 19. The barrier layer 20 is prepared, for example, by coating a vinylidene chloride film on a 14 $\mu$m thick polyester film. A polyester film layer 21 (which is 12 $\mu$m thick) is provided on the barrier layer 20, and a 1 $\mu$m thick, conductive layer 22, of for example, carbon is provided on the polyester film 21. The polyester film 21 reinforces the mechanical strength and dielectric resistance of the film 11 while the carbon conductive layer 22 prevents charge build-up. The carbon conductive layer 22 does not degrade with time and does not have any humidity dependence. The material of the protective layer 23 protects the carbon conductive layer 22, and hence prevents the formation of carbon flake dust. It has high abrasion resistance and printability.

Next, the method of using the humidity indicator 15 in the bag 17 will be explained briefly.

First of all, the humidity indicator 15 is mounted on the inner surface of the film 11 at a position where the indicator 15 is visible from outside of the bag 17, as shown in Fig. 7. In this embodiment the film 11 is transparent.

A plurality of containers 13 storing therein a plurality of electronic components 12 (semiconductor elements), such as surface package type semiconductor devices, are put into the inner box 14, the box 14 is then enclosed by the film 11 and the ends 11A and 11B of the film are sealed to form a moisture-proof package (the bag 17).

If the colour of the humidity indicator 15 has changed from blue to thin violet when the electronic components 12 are to be used, the components 12 should be taken out of the bag 17, baked at 125°C for 24 hours and subsequently mounted, using solder reflow, infrared lamp or vapour phase reflow.

As can be understood, the fact that the humidity indicator 15 is visible from the outside of the bag 17 means that the state of hygroscopicity inside the bag 17 can be confirmed from the outside. Accordingly, management of the moisture-proofing bags 17 is easy.

This embodiment can be applied to packaging of any electronic components, in addition to surface mount package type semiconductor devices described above, which are affected by humidity.

Embodiment 3

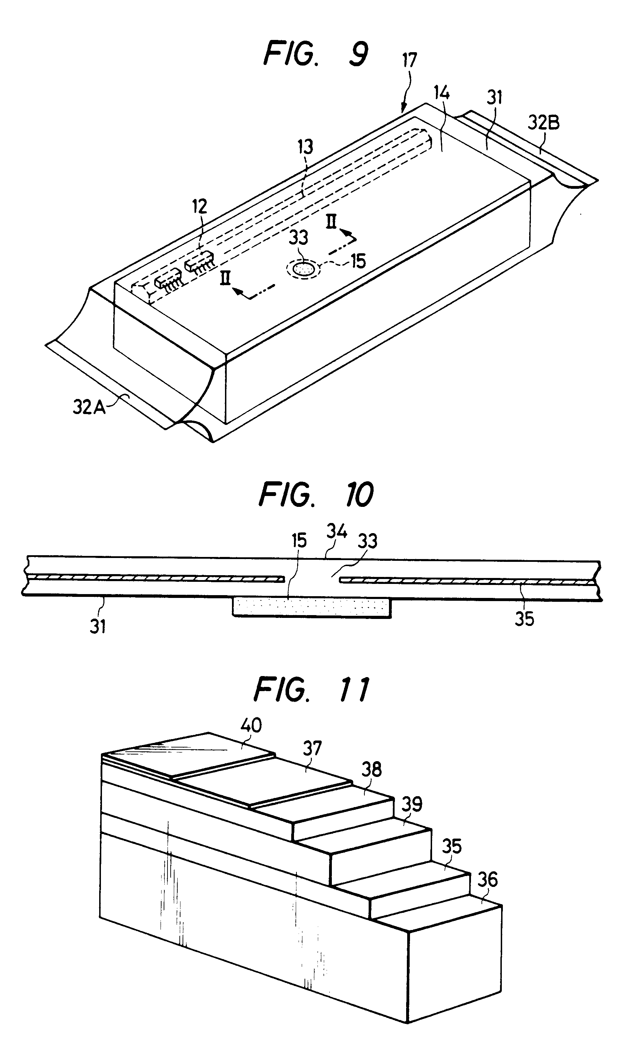

A third embodiment of the present invention will now be described with reference to Figs. 9 to 11, in which the container enclosing the semiconductor elements is, except for a window, opaque. Many features of this embodiment may be the same as the second embodiment, and the same reference numerals will be used, where appropriate.

As shown in Fig. 9, the moisture-proof container (bag) of this embodiment is made of an opaque film 31. A plurality of electronic components 12 (semiconductor elements), such as surface mount package type semiconductor devices, are put into carrier members, e.g. containers 13 and the containers 13 are then stored in an inner box 14. After this interior box 14 is enclosed in the film 31, and its ends 32A and 32B are sealed for moisture-proofing. There is a humidity indicator 15 for detecting the internal humidity of the moisture-proofing bag 17 on the inner surface of the film 31 at a position where it is visible from the outside through a transparent window 33 in the film 31. This humidity indicator 15 may be similar to those used in the second embodiment.

As shown in Figs. 9 and 10, peripheral parts of the humidity indicator (humidity detection label) 15 are bonded directly to the inside of a transparent window 33 in the opaque film 31 by an adhesive so that the indicator can be seen from outside the bag 17 through the window 33. This humidity detection label may be prepared, for example, by letting paper made of a pulp absorb a material which changes the colour by humidity, such as cobalt chloride. It is also possible to let the portion of the surface of the box 14 corresponding to the window 33 absorb such a material.

The part 34 of the film 31 forming the transparent window 33 may comprise a laminate sheet as shown in Fig. 8.

On the other hand, the other parts of the film 31 are made of an opaque sheet containing an aluminium film as shown in Fig. 11.

In Fig. 11, there is shown a polyethylene layer 36 into which an antistatic agent is kneaded and which is the innermost layer of the bag 17. The polyethylene layer 36 is 60 μm thick, for example, and prevents frictional charge, permits heat sealing of the bag 17, determines the ease of opening of the bag 17 and the like.

An aluminium foil 35 having high moisture-proofing is spread on this polyethylene layer 36. Since aluminium is a metal, it vapour permeability is much lower than that of organic films and can effectively prevent ingress of moisture. This aluminium foil is about 10 μm thick, for example. Furthermore, a polyethylene film layer 39 e.g. 20 μm thick having high heat moldability is provided on the aluminium foil 35. There is a polyester film layer 38 (which is 12 μm thick) having high mechanical strength and high withstand voltage on the polyethylene film and a 1 μm thick carbon conductive layer 37 on the polyester film layer 38. Furthermore, there is an acrylic type protective layer 40 on the carbon conductive layer 37. The polyester film layer 38 reinforces the mechanical strength and dielectric resistance of the film 31. The carbon conductive layer 37 does not degrade with time and does not have humidity dependence. The material of the protective layer 40 protects the carbon conductive layer 37, and prevents the formation of carbon flake dust. It has high abrasion resistance and high printability.

The method of using the humidity indicator 15 in the moisture-proof package bag 17 of this embodiment is the same as that of the second embodiment.

As can be understood, this embodiment locates the humidity indicator 15 for detecting the internal humidity of the opaque bag 17 at a window, so that is is visible from the outside. Accordingly, the state of hygroscopicity of the bag 17 can be confirmed from the outside and its management can then be made easy. Since the film 31 need not be broken, re-packaging is not necessary after confirmation.

The manufacture of a semiconductor element, such as a DRAM, will now be described. Such an element may be packaged in the way described for any of the three embodiments discussed above.

Since the structure and processes of the semiconductor chip (DRAM, logic IC) as the essence of the semiconductor devices (integrated circuit devices, electronic devices) dealt with in the present invention are described in U.S. Patent No. 4,612,565 (U.S. Serial No. 783,531, filed October 3, 1985) and No. 4,625,227 (U.S. Serial No. 744,151, filed June 13, 1985). Therefore, the description will be made by referring partly to these references.

After a wafer step is complete, a wafer is split into each chip by dicing using a rotary blade. The fabrication steps before and after the wafer step are described in "Electric Integrated Circuits", John Allison, 1975, by McGraw Hill Book Company, pp. 5-10, particularly in Fig. 1.3 (p. 7). As to the dicing technique, refer to U.S. Patent No. 4,016,855 (U.S. Serial No. 608,733, filed August 28, 1975).

Thereafter, each chip is die-bonded to a lead frame. For detail of die-bonding of various kinds of chips, refer to DE-A-3116406, JP-A-58-134452, JP-A-61-218139, JP-A-61-218150, U.S. Patent Application Serial No. 898,534 (filed August 21, 1986), JP-A-60-257160, JP-A-61-32452, and JP-A-61-78149.

Next, each bonding pad of each pellet and the inner lead terminal of the lead frame are bonded by bonding wires (about 30 $\mu$m thick) of Cu, Al, Au, or the like. Besides the various U.S. Patents and Patent Applications described above, refer also for the detail of this bonding technique to U.S. Patent No. 4,564,734 (U.S. Serial No. 476,268, filed March 17, 1983), U.S.Patent No. 4,301,464 (U.S. Serial No. 55,070, filed July 5, 1979), U.S. Patent Application Serial No. 898,535 (filed August 21, 1986), and GB-A-2157607.

Furthermore, an about 20 to 200 $\mu$m thick high purity polyimide layer or silicon resin layer is formed by potting on the chip after completion of bonding in order to prevent any soft errors by $\alpha$-rays. For the detail of resin coating, refer to U.S. Patent Application Serial No. 256,110. Resin coating for preventing the $\alpha$-ray soft error may be carried out during the wafer process. At this time, a suitable thickness is from about 10 $\mu$m to about 80 $\mu$m and the resin coating is formed by the combination of spin coating with photolithography in such a manner as to cover at least the memory cell mat.

After wire bonding is complete, the lead frame is molded into an epoxy resin material by transfer mold. As to the molding technique, refer to various U.S. Patents and Patent Applications described above as well as to "VLSI Technology", S.M. Sze, 1983, by McGraw-Hill Book Company, pp. 574-581.

After moldihng is complete, the lead frame is withdrawn from the molding die and after any fins on the lead are completely removed, the unnecessary portions of the lead frame are cut off, the molded member is cut away from the frame and the leads are shaped in a desired shape.

After these steps, the products are selected and marking is applied to the approved products. This marking step may be made before cutting the leads. In other words, Sn or the like is plated to the surface of the exposed lead frame after resin molding by electroplating. Thereafter, the resin molded member and the exposed surface of the lead frame are cleansed (washed with water) to remove the plating solution attaching to them, and after they are dried, they are put to an automatic marking machine for applying the mark.

In this marking, marks representing the kind of products, class, and the like, are simultaneously put to the resin-molded member such as MOS semiconductor devices by offset marking using a rotary drum (transfer drum) or relief direct mark while the lead frame to which a plurality of semiconductor devices are fixed is moved in a predetermined direction. At this time, static electricity develops between the transfer drum or the relief and the resin molded member, but since the frame is kept as a whole at the same potential, the static electricity does not affect the interior of the semiconductor pellet but is grounded. Thereafter, the printed marks are baked or dried by an ultraviolet or infrared drier or mere heat-treatment and adhered tightly to the resin molded member.

Thereafter, each semiconductor device is separated by punching, cutting and bending and each lead of each MOS semiconductor device or the like becomes simultaneously an independent lead. The leads are bent in the L-shape on the same side and a dual-in type MOS semiconductor device or the like free from dielectric breakdown is thus completed.

As described above, baking (mark baking) is made at 150°C for 3 to 5 hours in the case of marking by the ink. If laser marking is employed, on the other hand, baking for drying the ink is not particularly required. For the detail of laser marking, refer to EP-A-0157008.

After baking is complete, the resin molded electronic devices (such as integrated circuit devices, semiconductor devices) are put into the moisture-proofing bag shown in the foregoing two embodiments, either directly or through a suitable auxiliary member (magazine, tray, tape, reel, etc.), within a few days and preferably, within a few hours after completion, together with a desiccant such as silica gel, and are then sealed airtight.

Thereafter, the resin molded devices are packed into a shipment cardboard box or the like for shipment while being sealed in the bag.

These semiconductor devices are taken out from the moisture-proofing bag immediately before mounting. In an ordinary environment, they are taken out within two to three days or within a few hours, before use. The inventors of this invention found out that if they are exposed to the external air for more than one week, they absorb substantially completely the moisture in the external air. Various solder reflow processes are used for mounting the semiconductor devices.

The present invention may also be applied to other semiconductor components. Examples of these will now be described.

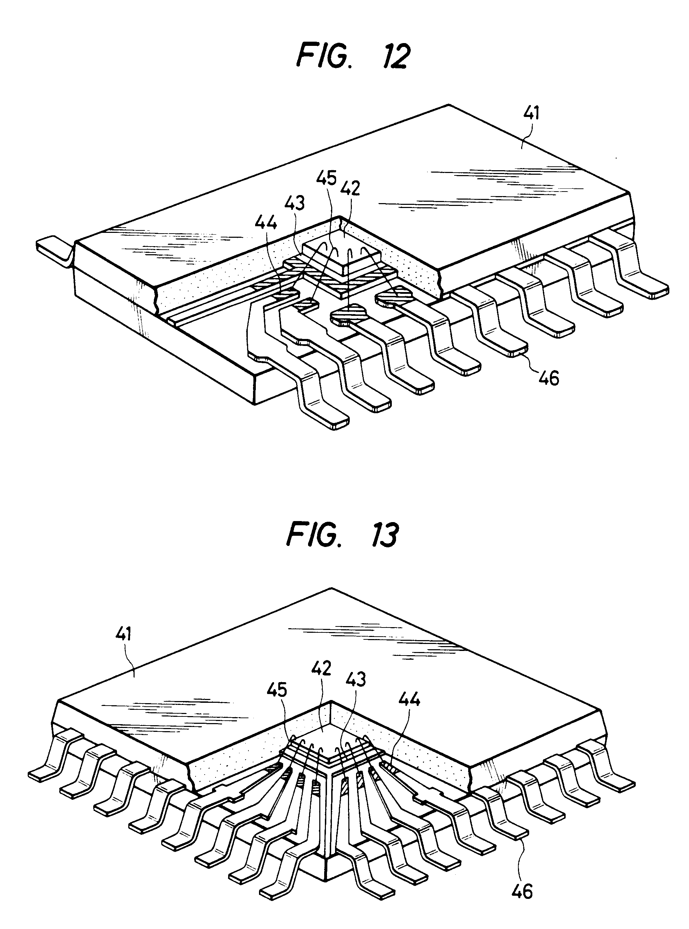

Fig. 12 shows an element which is called a "gull wing" and generally a "Small Outline Package (SOP)".

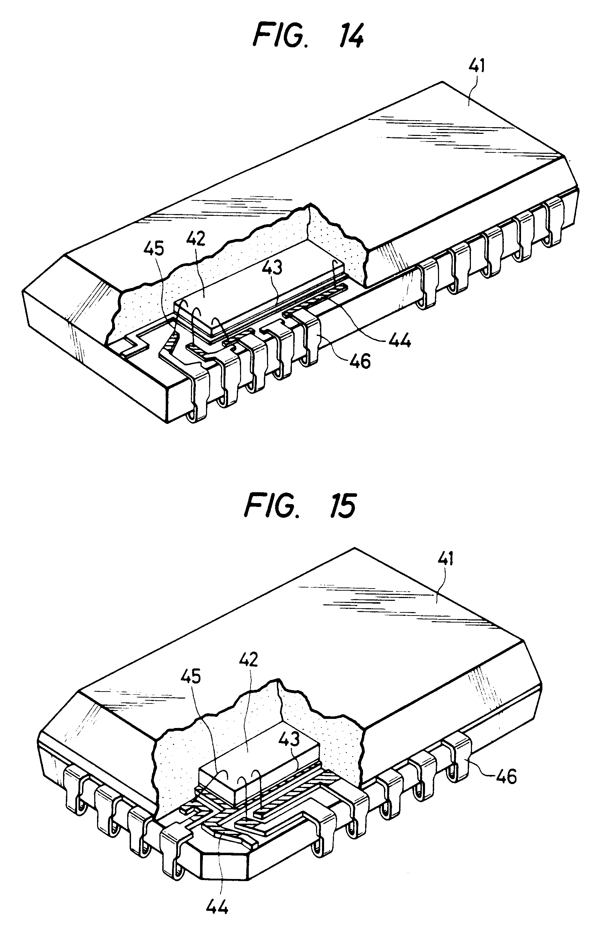

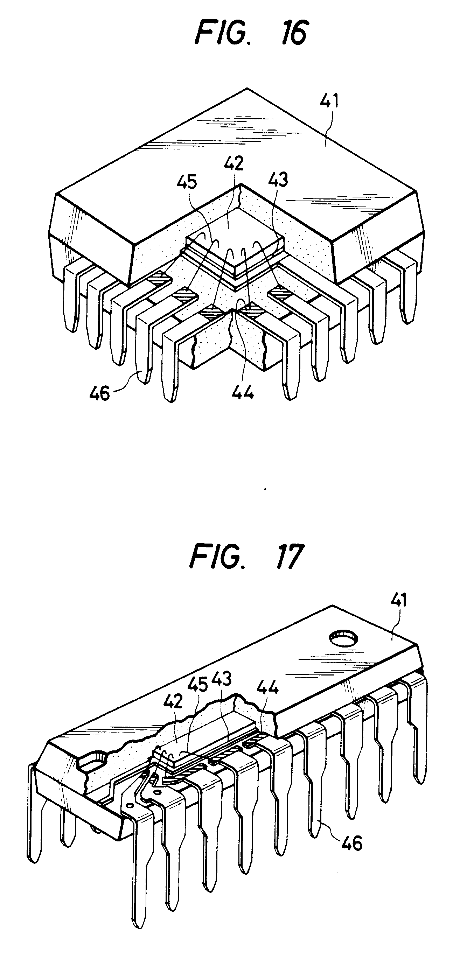

Fig 13 shows a surface mount element which is called a "flat plastic package (FPP) or a squad flat package (QFP)". Furthermore, Fig. 14 shows an element for use particularly in a semiconductor memory or the like, which is called a "small outline J-bend package (SOJ)". Fig. 15 shows an element which is called a "plastic leaded chip carrier (PLCC)" and is used for high density surface mount devices. Fig. 16 shows a device which belongs to the butt lead type and is called a "mini-squad package (MSP)".

Unlike the element mentioned above, the element shown in Fig. 17 is of a type in which leads are fitted into holes of a substrate. Therefore, it is an insert type and is generally called a "dual in-line package (DIP)".

In Figs. 12 to 17 described above, a semiconductor chip 42 is fixed using an Ag paste 43 to a holder such as tabs or islands made of a thin metal sheet. The bonding pads on the chip and inner leads having an Ag spot plating layer 44 formed thereon are subjected to ball and wedge bonding by capillary by an Au wire 45 (30 $\mu$m diameter), or the like. The leads 46 are formed by punching out from a 42-alloy or a copper alloy film. They are transfer-molded by an epoxy resin 41.

A large number of resin molded devices are stored in various carrier members and are then sealed airtight depending upon their applications.

The carrier members will now be explained.

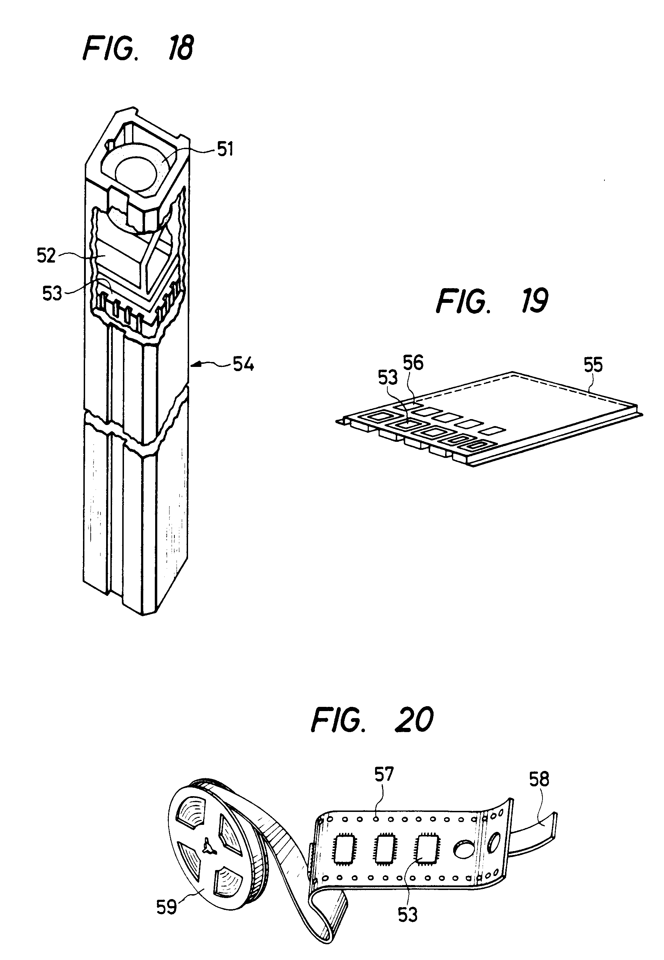

Fig. 18 shows a magazine 54 and the resin molded devices (transistors, ICs, LSIs, etc.) stored in the magazine 54. MSP type resin molded devices 53 are stacked vertically inside the magazine 54 and a polyethylene sub-stopper 52 and a main stopper made of hard nitrile rubber are packed into the end of the magazine. The main body of the magazine is made of hard polystylol containing carbon or electrically conductive soft vinyl chloride.

Fig. 19 shows a tray 55 forming a carrier member. The tray is made of vinyl chloride to which antistatic treatment is applied, and the resin molded devices 53 are put into square recesses 56 that are aligned in the form of array. In this case, it is possible to put directly silica gel or the like into each recess 56 and to seal the upper surface air-tight by the moisture-proofing sheet. Generally, after the trays are stacked, they are put into an inner box made of paper and then sealed into the moisture-proofing bag.

Fig. 20 shows a carrier member which is called a "tape and reel" system. The resin molded devices 53 are held in a line on a carrier tape 57 wound on a reel 59 through an adhesive tape 58. After the carrier tape 57 is wound on the reel 59, the reel is sealed air-tight one by one in the moisture-proofing bag.

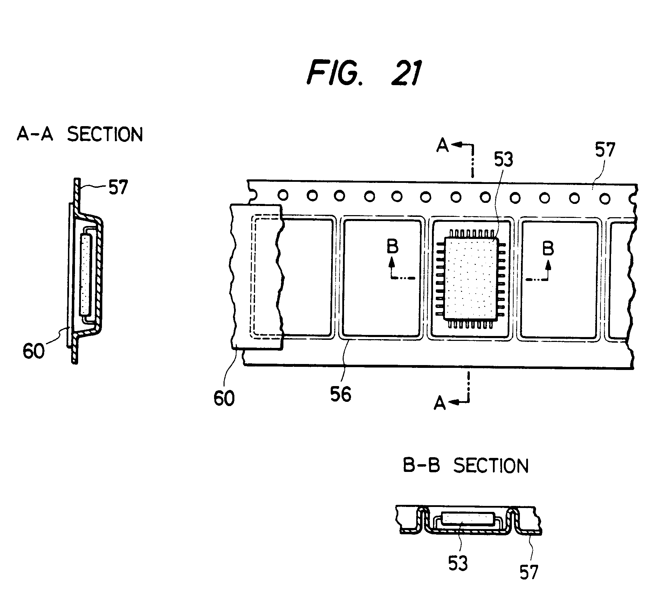

Fig. 21 shows another type of the tape and reel system. In this case, the resin molded devices 53 are stored in the square recesses 56 formed in a line on the carrier tape 57 and their upper surface is heat-sealed by a cover tape 60. The tape is wound on the reel under this state and the reel is sealed moisture-tight in the same way as above. In this case, too, the external moisture-proofing sheet can be elininated by changing the cover tape 60 to the moisture-proofing sheet shown in Fig. 8 or 11 and putting silica gel or the like into each recess 56.

Incidentally, refer to JP-A-62-16378 for the detail of production of magazine and the like.

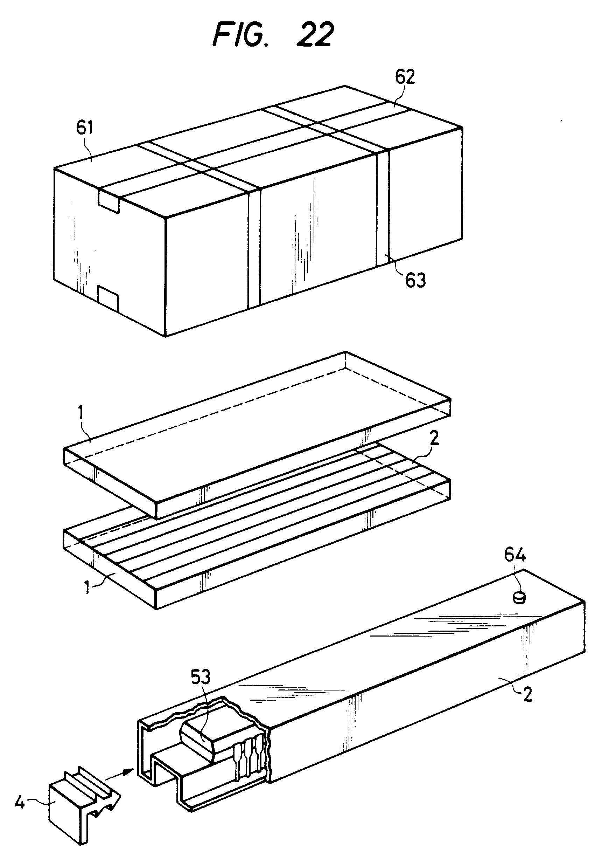

Fig. 22 shows an example of a shipment package of resin molded devices 53 (plug-in type or surface mount package type devices). A number of resin molded devices 53 are stored in a line inside the tube-like magazine 2 and secured fixedly by a stopper pin 64 and a stopper filler 4. A predetermined number of magazines are stored in the inner box 1 having low hygroscopicity, made of paper or sheet and stored inside the bag made of the moisture-proofing sheet such as shown in Fig. 8 or 11. The internal pressure of the bag becomes somewhat lower than that of the external air and deaeration is made so that the moisture-proofing bag comes substantially into close contact with the outer surface of the inner box and air-tight sealing is then made by pressurization or by heating. In this manner, the inner boxes can be stored easily in the outer box and the storage space becomes small.

On the other hand, the existence of any pinholes can be descriminated easily by putting dry $N_2$, which may be somewhat pressurized, into the bag in order to secure a gap between the moisture-proofing sheet and the inner box.

Though a description given above primarily deals with the magazine by way of example, packaging can be made substantially in the same way as above in the case of the tray and the tape and reel. In addition, either one or a plurality of the resin molded ICs may be put directly into the moisture-proofing bag.

It is also possible to put and seal the carrier member directly into the moisture-proofing bag without using the an inner box.

Though the desiccant is put into a paper bag or the like and then placed inside the interior box, it may be placed at a suitable air-tight position such as the recess of the magazine or the carrier tape. For instance, the desiccant may be coated and diffused on the inner surface of the moisture-proofing sheet.

As described above, a predetermined number of moisture-proofing bags that have been sealed air-tight are stored in the outer box 61 made of the cardboard and sealed by the adhesive tape 62. After the box is bound by bands 63, the box is shipped.

As to other air-tight sealing methods, particularly the method which uses the tray, refer to the afore-mentioned reference Japanese Patent Laid-Open No. 178877/1986.

The relationship between the sectional structure of the memory IC device and the package in the present invention will be explained. Here, the SOP type package will be described by way of example.

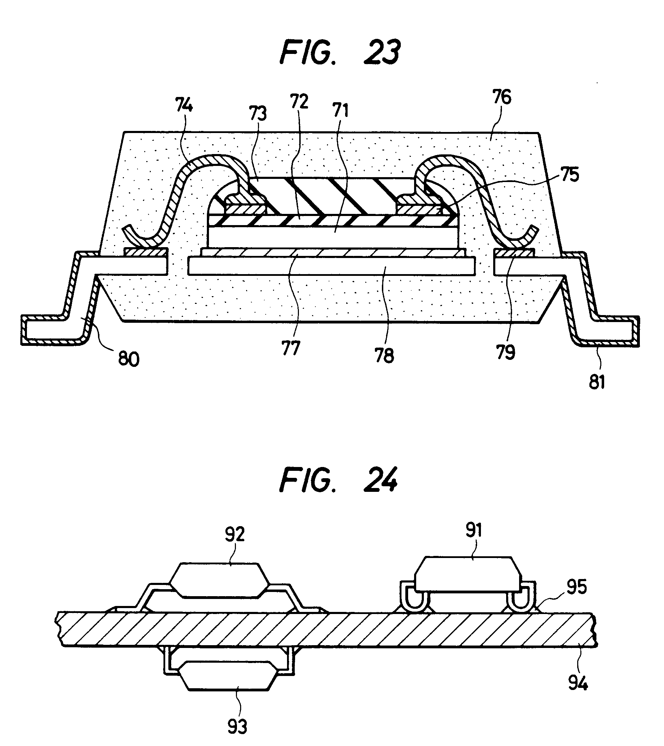

In Fig. 23, a very large number (about 1,000,000) of FETs constituting DRAM are formed on the upper main plane of the Si substrate 71. On the Si substrate are formed field oxide films forming these devices, insulation films (inorganic films) k72 made of an inter-level PSG (phospho silicate glass), and the like. A number of Aℓ bonding pads 75 are disposed further thereon.

On the other hand, the Si substrate 71 is fixed on its lower main plane to the islands or tabs 78 through the Ag paste 77. The size of this chip 71 is about 10 mm x 5 mm x 0.4 mm (high x wide x thick). The lead 80 is made of the same 42-alloy as that of the islands, and partial Ag plating 79 is disposed at the inner lead portion. After ball and wedge bonding is made to the gap between the inner end of the lead 80 and the bonding pad by an Au wire having a 30 μm diameter, a polyimide resin 73 is formed by potting onto substantially the entire upper surface of the chip from above the former. Thereafter, the structure is transfer-molded by an epoxy resin 76 in a lead frame unit. Solder plating 81 is applied to the lead portions protruding from the mold resin 76.

At this time, the 42-alloy member of the lead and island portion is 0.15 mm thick, the mold resin on the upper surface of the package is about 1 mm thick, the polyimide film is about 0.1 mm thick, the Ag paste is about 50 μm thick and the lower surface of the mold resin is about 1 mm thick.

In the package sealed by such a thin resin, if the absorbed moisture content is given, evaporation and expansion of the moisture occur first on the lower surface of the tab 78 due to drastic heating at the time of soldering and packaging. Subsequently, peel occurs between the resin and the metal and the package swells. The inventors found out that if the resin cannot withstand the resulting stress at this time, package crack develops.

Next, an outline of the surface mounting process will be given.

Desired wirings are formed on the substrate made of glass-epxoy resin, or the like, by a Cu film or the like, and a solder past is formed by screen printing or the like at solder portions (foot print) on the substrate. Then, the resin molded devices are mounted onto the solder paste by a vacuum chuck or like means, and solder in the paste is fused for soldering by the solder reflow method such as vapor phase reflow, heating furnace, infrared reflow, and like means.

Fig. 24 shows the state of mounting. In the drawing, reference numeral 91 represents the resin molded device of the SOJ type, 92 is the resin molded device of the SOP type and 93 is the resin molded device of the MSP type. Reference numeral 94 represents the wiring substrate and 95 is the solder which is reflowed or dipped.

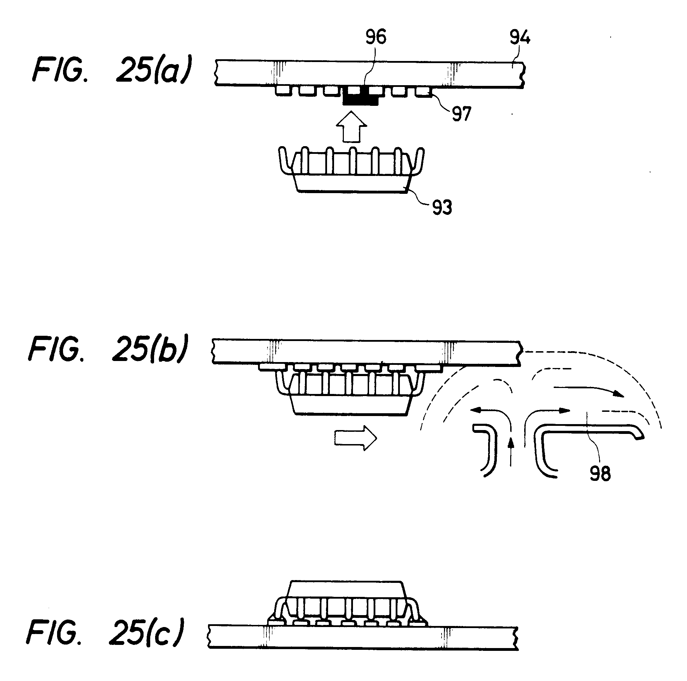

Fig. 25 snows the solder dipping method. As shown in Fig. 25(a), the resin molded device 93 or the MSP type is fixed in such a manner that its leads are placed on the screen-printed solder paste on the substrate 94 by the adhesive 96. Subsequently, it is dipped downwardly into the solder stream 98 as shown in Fig. 25(b) and is then cooled in such a manner as to attain the state shown in Fig. 25(c).

## Claims

1. A package comprising:

   a semiconductor element (3,12) having at least one semiconductor chip on which at least one electronic device is formed which semiconductor element (3,12) has not been mounted on an element substrate, and has at least one resin moulded member (41) covering all the main plane of the at least one chip; and

   a bag member (8,17) which surrounds the element (3,12) and seals the element in an air-tight manner;

   characterised in that:

   the element (3,12) is a surface mounting semiconductor element; and the bag member (8,17) comprises a multi-layered film containing at least one metal sheet (35) whereby moisture is prevented from reaching the element in the package so that cracking and interface peeling of the element can be avoided when mounting the element on an element substrate.

2. A package according to claim 1, wherein the moisture-proof bag member (8,17) includes a base member of polyester having moisture permeability up to 2.0g/m$^2$.24 hr.

3. A package according to claim 1 or claim 2 wherein the moisture-proof bag member (8,17) has a surface intrinsic resistance of up to $10^6$ ohms on the outer surface and up to $10^{11}$ ohms on the inner surface.

4. A package according to any one of the preceding claims wherein the bag member (8,17) has been heat-sealed, the interior of the bag member (8,17) deaerated.

5. A package to any one of the preceding claims wherein the prevention of moisture reaching the element is achieved by the low moisture permeability of the metal sheet (35).

6. A package according to any one of the preceding claims wherein the moisture-proof bag member (8,17) is a laminate (31) including a film layer that is a barrier layer for preventing intrusion of moisture.

7. A package according to claim 6, wherein said barrier layer is a polyester film having a vinylidene chloride film thereon.

8. A package according to claim 6 or claim 7 wherein said laminate (31) includes, in order, a first layer of polyethylene film having an antistatic agent therein, a polyester film layer having a pinhole proofing function, said film layer that is a barrier layer, a carbon conductive layer and a protective layer.

9. A package according to claim 8 wherein said laminate (31) further includes a polyester film between the film layer and the carbon conductive layer, for the reinforcement of mechanical strength and dielectric resistance.

10. An air-tight package made of a moisture-proof film which package comprises:

a plurality of semiconductor elements (3,12) which have not been mounted on an element substrate and each element includes a resin moulded semi conductor device;;

a plurality of storage magazines (2,13) arranged in lines and in close contact with one another for storage therein of said semiconductor elements (3,12);

a bag member (8,17) which surrounds the elements (3,12) and seals the elements (3,12) and magazines (2,13) in an air-tight manner;

characterised in that:

the elements (3,12) are surface mounting semiconductor elements;

the bag member (8,17) comprises a moisture-proofing sheet member, which is a multi layered film whereby moisture is prevented from reaching the elements in the package so that cracking and intersurface peeling of the element can be avoided when mounting the element on an element substrate;

an interior box (1) which contains said semiconductor element storage magazines (2,13) is provided within the bag member (8,17); and

a desiccant (5) is provided within the bag member (8,17).

11. An air-tight package according to claim 10 wherein the inside of said package is deaerated to such an extent that said package is substantially in close contact with said storage magazines (2,13).

12. A package according to claim 10 or claim 11 wherein the moisture-proofing sheet member is a laminate (31) which comprises a film layer that is a barrier layer to prevent intrusion of moisture into the bag member (8,17).

13. A package according to claim 12 wherein said barrier layer comprises a polyester film having a vinylidene chloride film thereon.

14. A package according to any one of claims 1 to 9 wherein each semiconductor element (3,12) is located in an interior box (1) positioned within said moisture-proof bag member (8,17).

15. A package according to any one of claims 1 to 9 wherein said moisture-proof bag member (8,17) surrounds a plurality of the semiconductor elements (3,12) and each semiconductor element (3,12) comprises a resin moulded member and its respective semiconductor chip.

16. A package according to any one of claims 1 to 9, 10-15 wherein the semiconductor element (3,12) is a gull wing element.

17. A package according to any one of claims 1 to 9, 10-15 wherein the semiconductor element (3,12) is a flat plastic package element.

18. A package according to any one of claims 1 to 9, 10-15 wherein the semiconductor element (3,12) is a small outline J-bend package element.

19. A package according to any one of claims 1 to 9, 11-15 wherein the semiconductor element (3,12) is a plastic leaded chip carrier.

20. A package according to any one of claims 1 to 9, wherein the metal sheet is of aluminium.

**Revendications**

1. Emballage comportant :

un élément à semiconducteurs (3, 12) possédant au moins une puce semiconductrice sur laquelle est formé au moins un dispositif électronique, élément à semiconducteurs (3, 12) qui n'a pas été monté sur un substrat, et possède au moins un élément de surmoulage en résine (41) recouvrant la totalité du plan principal de ladite au moins une puce ; et

un sac (8, 17) qui entoure l'élément (3, 12) et enferme celui-ci d'une manière hermétique à l'air ;

caractérisé en ce que :

l'élément (3, 12) est un élément à semiconducteurs devant être monté sur une surface ; et le sac (8, 17) comporte une pellicule à couches multiples contenant au moins une feuille métallique (35) de telle manière que l'humidité soit empêchée d'atteindre l'élément dans l'emballage de sorte qu'un fissurage et un arrachement interfacial de l'élément peuvent être évités lors du montage de l'élément sur un substrat.

2. Emballage selon la revendication 1, dans lequel le sac (8, 17) à l'épreuve de l'humidité comprend une base de polyester possédant une perméabilité à l'humidité jusqu'à 2,0 $g/m^2.24hr$.

3. Emballage selon la revendication 1 ou la revendication 2, dans lequel le sac (8, 17) à l'épreuve de l'humidité possède une résistance intrinsèque superficielle allant jusqu'à $10^6$ ohms sur la surface extérieure et jusqu'à $10^{11}$ ohms sur la surface intérieure.

4. Emballage selon l'une quelconque des revendications précédentes, dans lequel le sac (8, 17) a été scellé à chaud, et l'intérieur du sac (8, 17) désaéré.

5. Emballage selon l'une quelconque des revendications précédentes, dans lequel l'empêchement pour l'humidité d'atteindre l'élément est obtenu par la faible perméabilité à l'humidité de la feuille de métal (35).

6. Emballage selon l'une quelconque des revendications précédentes, dans lequel le sac (8, 17) à l'épreuve de l'humidité est un stratifié (31) comprenant une couche pelliculaire constituant une barrière d'arrêt pour empêcher une pénétration de l'humidité.

7. Emballage selon la revendication 6, dans lequel ladite couche d'arrêt est une pellicule de polyester portant une pellicule de chlorure de vinylidène.

8. Emballage selon la revendication 6 ou la revendication 7, dans lequel ledit stratifié (31) comprend, dans l'ordre, une première couche en pellicule de polyéthylène contenant un agent antistatique, une couche en pellicule de polyester jouant un rôle de protection contre les trous d'épingle, ladite couche pelliculaire qui est une barrière d'arrêt, une couche conductrice en carbone et une couche protectrice.

9. Emballage selon la revendication 8, dans lequel ledit stratifié (31) comprend en outre une pellicule de polyester entre la couche pelliculaire et la couche conductrice en carbone, pour un accroissement de la résistance métallique et de la résistance diélectrique.

10. Emballage hermétique à l'air constitué d'une pellicule à l'épreuve de l'humidité, lequel emballage comporte :

une pluralité d'éléments à semiconducteurs (3, 12) qui n'ont pas été montés sur un substrat et chaque élément comprenant un dispositif à semiconducteurs surmoulé dans une résine ;

une pluralité de magasins de stockage (2, 13) disposés en succession et en contact étroit entre eux pour un stockage à l'intérieur desdits éléments à semiconducteurs (3, 12) ;

un sac (8, 17) entourant les éléments (3, 12) et enfermant les éléments (3, 12) et les magasins (2, 13) d 'une manière hermétique à l'air ;

caractérisé en ce que :

les éléments (3, 12) sont des éléments à semiconducteurs devant être montés sur une surface ;

le sac (8, 17) comporte une feuille résistant à l'humidité, qui est une pellicule à couches multiples, de telle sorte que l'humidité est empêchée d'atteindre les éléments dans l'emballage, de sorte qu'un fissurage et un arrachement interfacial de l'élément peuvent être évités lors du montage de l'élément sur un substrat ;

une boîte intérieure (1) contenant lesdits magasins de stockage (2, 13) d'éléments à semiconducteurs est prévue à l'intérieur du sac (8, 17) ; et

un dessicateur (5) est disposé à l'intérieur du sac (8, 17).

11. Emballage hermétique à l'air selon la revendication 10, dans lequel l'intérieur dudit emballage est désaéré dans une mesure telle que ledit emballage est pratiquement en contact étroit avec lesdits magasins de stockage (2, 13).

12. Emballage selon la revendication 10 ou la revendication 11, dans lequel la feuille de protection contre l'humidité est un stratifié (31) qui comporte une couche pelliculaire constituant une barrière d'arrêt pour empêcher la pénétration de l'humidité dans le sac (8, 17).

13. Emballage selon la revendication 12, dans lequel ladite couche d'arrêt comporte une pellicule de polyester portant une pellicule de chlorure de vinylidène.

14. Emballage selon l'une quelconque des revendications 1 à 9, dans lequel chaque élément à semiconducteurs (3, 12) est disposé dans une boîte intérieure (1) placée à l'intérieur dudit sac de protection contre l'humidité (8, 17).

15. Emballage selon l'une quelconque des revendications 1 à 9, dans lequel ledit sac de protection contre l'humidité (8, 17) entoure une pluralité d'éléments à semiconducteurs (3, 12) et chaque élément à semiconducteurs (3, 12) comporte un surmoulage de résine et sa puce semiconductrice respective.

16. Emballage selon l'une quelconque des revendications 1 à 9, 10-15, dans lequel l'élément à semiconducteurs (3, 12) est un élément à aile de mouette.

17. Emballage selon l'une quelconque des revendications 1 à 9, 10-15, dans lequel l'élément à semiconducteurs (3, 12) est un élément à boîtier en matière plastique plat.

18. Emballage selon l'une quelconque des revendications 1 à 9, 10-15, dans lequel l'élément à semiconducteurs (3, 12) est un petit élément à boîtier courbé à profil en J.

19. Emballage selon l'une quelconque des revendications 1 à 9, 11-15, dans lequel l'élément à semiconducteurs (3, 12) est un support de puce muni de conducteurs, en matière plastique.

20. Emballage selon l'une quelconque des revendications 1 à 9, dans lequel la feuille de métal est en aluminium.

**Patentansprüche**

1. Verpackung, mit

einem Halbleiterelement (3, 12) mit wenigstens einem Halbleiterchip, auf dem wenigstens ein elektronisches Bauelement ausgebildet ist, wobei das Halbleiterelement (3, 12) noch nicht auf einem Elementträger angebracht ist und wenigstens ein Kunstharz-Formteil (41) aufweist, das die gesamte Hauptebene des wenigstens einen Chips bedeckt; und mit

einem Beutel (8, 17), der das Element (3, 12) umgibt und das Element luftdicht abschließt;

dadurch **gekennzeichnet,** daß

das Element (3, 12) ein oberflächenmontierbares Halbleiterelement ist; und daß der Beutel (8, 17) eine Mehrschichtfolie mit wenigstens einer Metallschicht (35) umfaßt, wodurch verhindert wird, daß Feuchtigkeit das Element in der Verpackung erreicht, so daß beim Anbringen des Elementes auf dem Elementträger eine Rißbildung und eine Grenzflächenablösung am Element vermieden werden kann.

2. Verpackung nach Anspruch 1, wobei der feuchtigkeitsdichte Beutel (8, 17) eine Basis aus Polyester enthält, die eine Feuchtigkeits-Durchlässigkeit von bis zu 2,0 g/m$^2$.24 Std. aufweist.

3. Verpackung nach Anspruch 1 oder 2, wobei der feuchtigkeitsdichte Beutel (8, 17) einen Oberflächen-Eigenwiderstand von bis zu 10$^6$ Ohm an der äußeren Oberfläche und von bis zu 10$^{11}$ Ohm an der inneren Oberfläche aufweist.

4. Verpackung nach einem der vorstehenden Ansprüche, wobei der Beutel (8, 17) heiß versiegelt und das Innere des Beutels (8, 17) luftleer gemacht worden ist.

5. Verpackung nach einem der vorstehenden Ansprüche, wobei die Verhinderung, daß Feuchtigkeit das Element erreicht, durch die niedrige Feuchtigkeits-Durchlässigkeit der Metallschicht (35) erzielt wird.

6. Verpackung nach einem der vorstehenden Ansprüche, wobei der feuchtigkeitsdichte Beutel (8, 17) ein Laminat (31) mit einer Folienschicht ist, die eine Sperrschicht gegen das Eindringen von Feuchtigkeit ist.

7. Verpackung nach Anspruch 6, wobei die Sperrschicht eine Polyesterschicht mit einem Vinylidenchloridfilm darauf ist.

8. Verpackung nach Anspruch 6 oder 7, wobei das Laminat (31), in dieser Reihenfolge, eine erste Schicht aus einem Polyethylenfilm mit einem Antistatikmittel darin, eine Polyesterfolienschicht mit einer Pinhole-festen Funktion, wobei die Folienschicht eine Sperrschicht ist, eine leitfähige Kohlenstoffschicht und eine Schutzschicht aufweist.

9. Verpackung nach Anspruch 8, wobei das Laminat (31) des weiteren eine Polyesterschicht zwischen der Folienschicht und der leitfähigen Kohlenstoffschicht zur Erhöhung der mechanischen Festigkeit und der dielektrischen Widerstandsfähigkeit aufweist.

10. Luftdichte Verpackung aus einer feuchtigkeitsdichten Folie, wobei die Verpackung umfaßt:
eine Anzahl von Halbleiterelementen (3, 12), die noch nicht auf einem Elementträger angebracht sind, wobei jedes Element ein in Kunstharz eingegossenes Halbleiterbauteil enthält;
eine Anzahl von Aufbewahrungsmagazinen (2, 13), die der Reihe nach angeordnet sind und die miteinander in engem Kontakt stehen, um die Halbleiterelemente (3, 12) darin aufzubewahren;
einen Beutel (8, 17), der die Elemente (3, 12) umgibt und die Elemente (3, 12) und Magazine (2, 13) luftdicht abschließt;
dadurch **gekennzeichnet,** daß
die Elemente (3, 12) oberflächenmontierbare Halbleiterelemente sind; daß
der Beutel (8, 17) ein feuchtigkeitsdichtes Folienteil aufweist, das eine Mehrschichtfolie ist, wodurch verhindert wird, daß Feuchtigkeit die Elemente in der Verpackung erreicht, so daß beim Anbringen der Elemente auf dem Elementträger eine Rißbildung und eine Grenzflächenablösung am Element vermieden werden kann; daß
eine innere Schachtel (1) im Beutel (8, 17) vorgesehen ist, die die Aufbewahrungsmagazine (2, 13) für die Halbleiterelemente enthält;

und daß
im Beutel (8, 17) ein Trockenmittel (5) vorgesehen ist.

11. Luftdichte Verpackung nach Anspruch 10, wobei das Innere der Verpackung in einem solchen Ausmaß luftleer gemacht worden ist, daß die Verpackung im wesentlichen mit den Aufbewahrungsmagazinen (2, 13) in engem Kontakt steht.

12. Verpackung nach Anspruch 10 oder 11, wobei das feuchtigkeitsdichte Folienteil ein Laminat (31) ist, das eine Folienschicht umfaßt, die eine Sperrschicht zur Verhinderung des Eindringens von Feuchtigkeit in den Beutel (8, 17) ist.

13. Verpackung nach Anspruch 12, wobei die Sperrschicht eine Polyesterschicht mit einem Vinylidenchloridfilm darauf ist.

14. Verpackung nach einem der Ansprüche 1 bis 9, wobei jedes Halbleiterelement (3, 12) in einer inneren Schachtel (1) angeordnet ist, die sich in dem feuchtigkeitsdichten Beutel (8, 17) befindet.

15. Verpackung nach einem der Ansprüche 1 bis 9, wobei der feuchtigkeitsdichte Beutel (8, 17) eine Anzahl von Halbleiterelementen (3, 12) umgibt und jedes Halbleiterelement (3, 12) ein Kunstharz-Formteil und den jeweiligen Halbleiterchip aufweist.

16. Verpackung nach einem der Ansprüche 1 bis 9 und 10 bis 15, wobei das Halbleiterelement (3, 12) ein Element mit abgewinkelten Anschlüssen ist.

17. Verpackung nach einem der Ansprüche 1 bis 9 und 10 bis 15, wobei das Halbleiterelement (3, 12) ein Element mit flachem Kunststoffgehäuse ist.

18. Verpackung nach einem der Ansprüche 1 bis 9 und 10 bis 15, wobei das Halbleiterelement (3, 12) ein Element in einem Gehäuse kleiner Bauform mit J-Anschlüssen ist.

19. Verpackung nach einem der Ansprüche 1 bis 9 und 11 bis 15, wobei das Halbleiterelement (3, 12) ein Kunststoffchipträger mit Anschlüssen ist.

20. Verpackung nach einem der Ansprüche 1 bis 9, wobei die Metallschicht aus Aluminium ist.

14

## FIG. 1

## FIG. 2

## FIG. 3

## FIG. 4

## FIG. 5

FIG. 6

FIG. 7

FIG. 8

FIG. 9

FIG. 10

FIG. 11

## FIG. 12

## FIG. 13

## FIG. 14

## FIG. 15

## FIG. 16

## FIG. 17

FIG. 18

51

52

53

54

FIG. 19

53  56

55

FIG. 20

57

58

59

53

# FIG. 21

A-A SECTION

57

60

A 53 57

B B

60 56 A

B-B SECTION

53 57

## FIG. 22

## FIG. 23

## FIG. 24

FIG. 25(a)

FIG. 25(b)

FIG. 25(c)